# NEUE EUROPÄISCHE PATENTSCHRIFT

(11) **EP 1 699 637 B2**
(45) Veröffentlichungstag und Bekanntmachung des Hinweises auf die Entscheidung über den Einspruch: **27.12.2017**
(45) Hinweis auf die Patenterteilung: 21.01.2015
(21) Anmeldenummer: 04730518.0
(22) Anmeldetag: 30.04.2004
(51) Int. Cl.: B41M 1/22, B41F 17/00, H01L 51/00, G06K 19/077, H05K 3/12

(54) **VERFAHREN ZUM ZUSÄTZLICHEN BEDRUCKEN MIT ELEKTRISCHER LEITFÄHIGKEIT**
METHOD FOR FURTHER PRINTING WITH ELECTRICAL CONDUCTIVITY
PROCEDE PERMETTANT D'IMPRIMER EGALEMENT LA CONDUCTIVITE ELECTRIQUE

(30) Priorität: 01.08.2003 DE 10335230; 15.01.2004 DE 102004002132; 13.02.2004 DE 102004007457; 13.02.2004 DE 102004007458
(43) Veröffentlichungstag der Anmeldung: 13.09.2006
(73) Patentinhaber: manroland web systems GmbH, 86153 Augsburg (DE)
(72) Erfinder: SCHNEIDER, Josef, 86420 Diedorf (DE); BAUMANN, Reinhard, 82152 Krailling (DE); DILLING, Peer, 86316 Friedberg (DE); WEISS, Robert, 86368 Gersthofen (DE)
(86) Internationale Anmeldenummer: PCT/EP2004/004623
(87) Internationale Veröffentlichungsnummer: WO 2005/021276

(56) Entgegenhaltungen:
- EP-A- 0 615 285
- WO- -01/18749
- WO-A-01/37623
- WO-A-96/40443
- WO-A-03/011607
- DE-B- 1 245 993
- US-A- 5 426 074
- US-B1- 6 470 797

## Beschreibung

Die Erfindung betrifft ein Verfahren zum Bedrucken eines Bedruckstoffs gemäß dem Oberbegriff des Patentanspruchs 1.

Die vorliegende Anmeldung beansprucht die Prioritäten der Deutschen Patentanmeldungen DE 10335230.9, DE 102004007458.5, DE 102004007457.7 und DE 102004002132.5.

Zum Drucken wird nach dem Stand der Technik ein Bedruckstoff vorzugsweise durch mehrere Druckwerke bewegt, wobei vorzugsweise in jedem Druckwerk eine Druckfarbe auf den Bedruckstoff aufgetragen wird. Im autotypischen Zusammendruck werden vorzugsweise in vier hintereinander geschalteten Druckwerken die Druckfarben Schwarz, Cyan, Magenta und Gelb gedruckt. Beim Drucken dieser Druckfarben zum autotypischen Zusammendruck wird demnach ausschließlich die Funktionalität Farbe gedruckt. Soll eine von der Funktionalität Farbe abweichende Funktionalität auf den Bedruckstoff aufgebracht werden, so wird der Bedruckstoff nach dem Stand der Technik offline zu den für die Funktionalität Farbe verantwortlichen Druckwerken durch spezielle Druckeinrichtungen bewegt. Zum Drucken der Funktionalität Farbe sowie zum Drucken einer von der Funktionalität Farbe abweichenden Funktionalität muss demnach der Bedruckstoff zwischen den Druckwerken einer Druckmaschine und den hiervon entkoppelten Druckeinrichtungen bewegt werden. Hierdurch wird der gesamte Druckprozess aufwendig und teuer.

Aus der WO 96/40443 A1 ist eine Druckmaschine zum direkten Drucken von Komponenten mit elektrischen Schaltkreisen auf Substrate bekannt, die eine elektrisch leitende Flüssigkeit nutzt. Weiterhin wird ein Verfahren zum Verwenden der Druckmaschine beschrieben. Zum Drucken der Flüssigkeit werden in der Druckmaschine Zellen vorgesehen, die untereinander verbunden sind und die die Flüssigkeit beim Drucken aufnehmen und abgeben. Die Druckmaschine weist Einrichtungen zum Auftragen dielektrischer, leitender und isolierender Medien auf. Weiterhin sind Einrichtungen zum Auftragen von Spezialflüssigkeiten und Druckfarben, sowie zum Auftragen einer Schutzschicht vorgesehen.

Aus der US 5,426,074 ist ein Verfahren zur Herstellung eines Schaltkreises mit einer aktiven Matrix bekannt. Hierbei ist ein Druckwerk vorgesehen, mit dem im Offsetdruck ein gegen Ätzung schützendes Muster auf einem Substrat mit einer speziellen Beschichtung aufgebracht werden kann. Die so bedruckte Obertläche des Substrats wird dann geätzt und gereinigt, um den elektrischen Schaltkreis fertig zu stellen.

Hiervon ausgehend liegt der hier vorliegenden Erfindung das Problem zugrunde, ein neuartiges Verfahren zum Bedrucken eines Bedruckstoffs zu schaffen.

Dieses Problem wird durch ein Verfahren gemäß Patentanspruch 1 gelöst.

Mit der hier vorliegenden Erfindung wird erstmals vorgeschlagen, die Funktionalität Farbe sowie die Funktionalität elektrische Leitfähigkeit und/oder die Funktionalität elektrische Halbleitfähigkeit dadurch gemeinsam bzw. in einem Workflow auf einen Bedruckstoff aufzutragen, dass derselbe zum Drucken der Funktionalität Farbe durch mindestens ein Druckwerk bewegt wird, und dass derselben zum Drucken der Funktionalität elektrische Leitfähigkeit und/oder der Funktionalität elektrische Halbleitfähigkeit durch mindestens eine, mit dem oder jedem für die Funktionalität Farbe verantwortlichen Druckwerk inline geschaltete Druckeinrichtung zu bewegen. Hierdurch wird der gesamte Druckprozess für derartige Druckerzeugnisse erheblich vereinfacht und damit kostengünstig.

Erfindungsgemäß werden in der oder jeden Druckeinrichtung zum Drucken der Funktionalität elektrische Leitfähigkeit elektrische Leiterbahnen auf den Bedruckstoff derart gedruckt, dass eine Antenne bereitgestellt wird. Im Anschluss hieran wird ein Chip auf den Bedruckstoff elektrisch kontaktierend mit der Antenne aufgeklebt.

Nach einer weiteren vorteilhaften Weiterbildung der Erfindung werden in den Druckeinrichtungen zum Drucken der Funktionalität elektrische Halbleitfähigkeit halbleitfähige Materialen, isolierende Materialen und leitfähige Materialen derart auf den Bedruckstoff gedruckt, dass Transistoren und aus Transistoren zusammengefügte Halbleiterchips bereitgestellt werden.

Bevorzugte Weiterbildungen der Erfindung ergeben sich aus den Unteransprüchen und der nachfolgenden Beschreibung.

Ausführungsbeispiele der Erfindung werden, ohne hierauf beschränkt zu sein, an Hand der Zeichnung näher erläutert. Dabei zeigt:
- Fig. 1:: eine schematisierte Darstellung einer Vorrichtung zur Durchführung des erfindungsgemäßen Verfahrens zum Bedrucken eines Bedruckstoffs nach einem ersten Ausführungsbeispiel der Erfindung; und
- Fig. 2:: eine schematisierte Darstellung einer Vorrichtung zur Durchführung des erfindungsgemäßen Verfahrens zum Bedrucken eines Bedruckstoffs nach einem zweiten Ausführungsbeispiel der Erfindung.

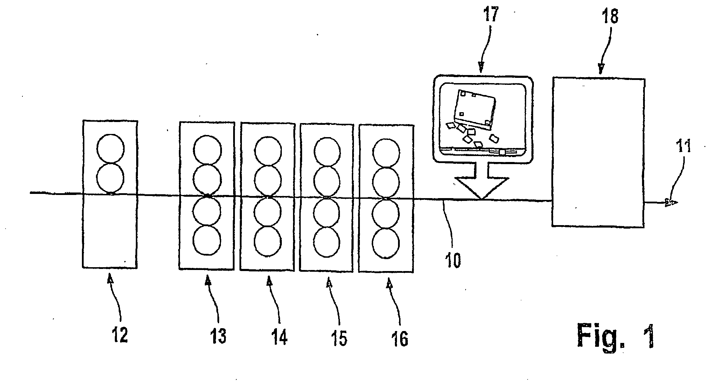

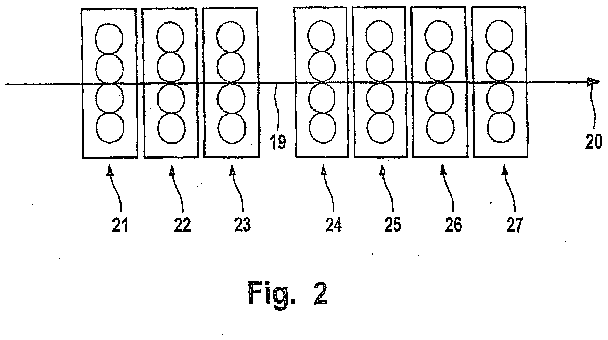

Nachfolgend wird die hier vorliegende Erfindung unter Bezugnahme auf Fig. 1 und 2 in größerem Detail beschrieben.

Fig. 1 zeigt stark schematisiert den erfindungsgemäßen Verfahrensablauf zur Herstellung eines Druckerzeugnisses nach einem ersten Ausführungsbeispiel der Erfindung. Gemäß Fig. 1 wird ein Bedruckstoff 10 im Sinne des Pfeils 11 zuerst durch eine Druckeinrichtung 12 zum Drucken der Funktionalität elektrische Leitfähigkeit bewegt. Obwohl in Fig. 1 lediglich eine Druckeinrichtung 12 zum Drucken der Funktionalität elektrische Leitfähigkeit gezeigt ist, können auch mehrere derartige Druckeinrichtungen inline hintereinander angeordnet sein. In der Druckeinrichtung 12 werden demnach auf den Bedruckstoff 10 elektrische Leiterbahnen gedruckt. Bevorzugt werden die elektrischen Leiterbahnen derart auf den Bedruckstoff 10 gedruckt, dass dieselben mindestens eine Antenne bereitstellen. Die Leiterbahnen werden dabei derart auf den Bedruckstoff 10 aufgedruckt, dass auf dem letztendlich herzustellenden Druckerzeugnis, zum Beispiel auf einer Verpackung, mindestens eine Antenne angeordnet ist. Besonders bevorzugt werden die Leiterbahnen derart auf den Bedruckstoff 10 aufgebracht, dass auf jedem herzugstellenden Druckerzeugnis, also zum Beispiel auf jeder herzustellenden Verpackung, mehrere Antennen vorhanden sind, um so eine Redundanz zu gewährleisten.

Nach dem Drucken der Funktionalität elektrische Leitfähigkeit in der Druckeinrichtung 12 wird der Bedruckstoff 10 im Ausführungsbeispiel der Fig. 1 durch vier Druckwerke 13, 14, 15 und 16 bewegt, wobei die Druckwerke 13 bis 16 inline zu der Druckeinrichtung 12 angeordnet sind und allesamt dem Drucken der Funktionalität Farbe dienen. In jedem der Druckwerke 13 bis 16 wird demnach eine zum autotypischen Zusammendruck verwendete Prozessfarbe Schwarz, Magenta, Cyan oder Gelb verdruckt. Die Funktionalität Farbe kann dabei derart auf den Bedruckstoff 10 aufgedruckt werden, dass die zuvor in der Druckeinrichtung 12 aufgedruckten, mindestens eine Antenne bereitstellenden Leiterbahnen bereichsweise überdeckt werden.

Im Ausführungsbeispiel der Fig. 1 wird nach dem Aufdrucken der elektrischen Leiterbahnen in der Druckeinrichtung 12 und nach dem Aufdrucken der Funktionalität Farbe in den Druckwerken 13 bis 16 auf den Bedruckstoff 10 in einer Bearbeitungsstation 17 mindestens ein Chip aufgebracht, insbesondere aufgeklebt, wobei der oder jeder Chip elektrisch kontaktierend mit jeweils einer in der Druckeinrichtung 12 aufgedruckten Antenne auf den Bedruckstoff 10 aufgebracht, insbesondere aufgeklebt, wird. Bei dem Chip handelt es sich insbesondere um einen sogenannten RFID (Radio Frequency Identity)-Tag, der als passiver, semipassiver oder aktiver RFID-Tag ausgebildet sein kann. Die Bearbeitungsstation 17 ist inline zu den Druckwerken 13 bis 16 und damit auch inline zu der Druckeinrichtung 12 angeordnet, wobei die Druckwerke 13 bis 16 der Druckeinrichtung 12 inline nachgeschaltet sind, und wobei die Bearbeitungsstation 17 der Druckeinrichtung 12 inline nachgeschaltet ist.

In einer der Bearbeitungsstation 17 inline nachgeschalteten Bearbeitungsstation 18 wird vorzugsweise ein sogenanntes Finishing des Bedruckstoffs 10 durchgeführt. So kann in der Bearbeitungsstation 18 zum Beispiel eine Schutzfolie oder ein Schutzlack auf den oder jeden aufgeklebten Chip aufgebracht werde. Weiterhin kann in der Bearbeitungsstation 18 zum Beispiel eine Programmierung des oder jeden insbesondere aufgeklebten Chips erfolgen.

Auf die obige Art und Weise können zum Beispiel intelligente Verpackungen durch die Drucktechnik auf einfache und kostengünstige Art und Weise hergestellt werden. Hierdurch ist es möglich, konventionelle Barcodes durch intelligente, mithilfe der Drucktechnik aufgebrachter Chiptechnologie zu ersetzen. Im Ausführungsbeispiel der Fig. 1 werden demnach die elektrischen Leiterbahnen durch Drucktechnik zusätzlich zur Funktionalität Farbe inline in einem Druckverfahren auf den Bedruckstoff 10 aufgebracht. Die Chips werden auf den Bedruckstoff 10 vorzugsweise aufgeklebt, und zwar ebenfalls inline zu der Druckeinrichtung 12 und den Druckwerken 13 bis 16.

Fig. 2 zeigt ein zweites Ausführungsbeispiel eines erfindungsgemäßen Verfahrens zum Bedrucken eines Bedruckstoffs 19, wobei der Bedruckstoff 19 im Sinne des Pfeils 20 zuerst durch drei Druckeinrichtungen 21, 22 und 23 zum Drucken der Funktionalität elektrische Halbleitfähigkeit und im Anschluss daran durch vier Druckwerke 24, 25, 26 und 27 zum Drucken der Funktionalität Farbe bewegt wird, wobei die Druckwerke 24 bis 27 inline zu den Druckeinrichtungen 21 bis 23 angeordnet bzw. geschaltet sind.

Beim Drucken der Funktionalität elektrische Halbleitfähigkeit werden auf den Bedruckstoff 19 in den Druckeinrichtungen 21, 22 und 23 aktive Bauelemente in Form von Transistoren auf den Bedruckstoff 19 aufgedruckt, wobei die Transistoren zu Halbleiterchips verschaltet sind. Hierzu wird zuerst in der Druckeinrichtung 21 ein elektrisch halbleitfähiges Material auf den Bedruckstoff 19 aufgedruckt. Darauffolgend wird in der Druckeinrichtung 22 ein elektrisch isolierendes Material und in der Druckeinrichtung 23 ein elektrisch leitfähiges Material aufgedruckt. Durch das hintereinander geschaltete Verdrucken von halbleitfähigen, isolierenden und elektrisch leitfähigen Materialien können Transistoren auf den Bedruckstoff 19 aufgedruckt werden. Die in den Druckeinrichtungen 21, 22 und 23 aufgetragenen Materialen ergänzen sich also in ihrer Funktionalität zur Funktionalität Halbleitschaltungen drucktechnisch bereitzustellen. In der Druckeinrichtung 21 werden insbesondere elektrisch halbleitfähige Polymere, wie Polyaniline oder Polyethylenidoxythiophene verdruckt. Derartige elektrisch halbleitfähige Polymere eignen sich bevorzugt zum Drucken halbleitfähiger Strukturen.

Nach dem Aufdrucken der Transistoren bzw. der aus Transistoren zusammengesetzten Halbleiterchips auf den Bedruckstoff 19 in den Druckeinrichtungen 21 bis 23 kann auf konventionelle Art und Weise in den Druckwerken 24 bis 27 inline zu den Druckeinrichtungen 21 bis 23 die Funktionalität Farbe auf den Bedruckstoff 19 aufgetragen werden.

Mit dem erfindungsgemäßen Verfahren nach dem Ausführungsbeispiel der Fig. 2 ist es möglich, Halbleiterstrukturen mithilfe der Drucktechnologie auf einfache und kostengünstige Weise inline zum Drucken der Funktionalität Farbe auf den Bedruckstoff 19 aufzutragen. Hierdurch wird es möglich, besonders kostengünstige Halbleiterchip zum Beispiel auf Verpackungen aufzudrucken.

In den Ausführungsbeispielen der Fig. 1 und 2 sind die Druckwerke 13 bis 16 bzw. 24 bis 27 zum Drucken der Funktionalität Farbe inline den Druckeinrichtungen 12 bzw. 21 bis 23 zum Drucken der Funktionalität elektrische Leitfähigkeit bzw. elektrische Halbleitfähigkeit nachgeschaltet. Weiterhin sei darauf hingewiesen, dass die Auflagenhöhe beim Drucken der Funktionalität elektrische Leitfähigkeit bzw. elektrische Halbleitfähigkeit der Auflagenhöhe beim Drucken der Funktionalität Farbe entsprechen kann. Insbesondere wird jedoch die Auflagenhöhe beim Drucken der Funktionalität Farbe geringer sein als die Auflagenhöhe beim Drucken der Funktionalität Leitfähigkeit bzw. elektrische Leitfähigkeit.

Hierdurch ist es möglich, den Bedruckstoff mit der immer gleichen elektrischen Funktionalität bzw. der immer gleichen halbleitenden Funktionalität zu bedrucken, das jeweilige Bedruckbild, welches bei Drucken der Funktionalität Farbe entsteht, jedoch zu variieren. Es kann auch noch inline eine transparente oder auch nichttransparente Schutzschicht auf die gedruckten elektrischen Leiterbahnen oder die gedruckten halbleitfähigen Strukturen aufgebracht werden.

Mithilfe der hier vorliegenden Erfindung ist es möglich, Druckerzeugnisse einer völlig neuen Funktionalität zuzuführen und derartige Druckerzeugnisse auf einfache und kostengünstige Art und Weise herzustellen.

### Bezugszeichenliste

- 10: Bedruckstoff
- 11: Pfeil
- 12: Druckeinrichtung
- 13: Druckwerk
- 14: Druckwerk
- 15: Druckwerk
- 16: Druckwerk
- 17: Bearbeitungsstation
- 18: Bearbeitungsstation
- 19: Bedruckstoff
- 20: Pfeil
- 21: Druckeinrichtung
- 22: Druckeinrichtung
- 23: Druckeinrichtung
- 24: Druckwerk
- 25: Druckwerk
- 26: Druckwerk
- 27: Druckwerk

## Patentansprüche

1. Verfahren zum Bedrucken eines Bedruckstoffs, wobei der Bedruckstoff - zum Drucken der Funktionalität Farbe durch mindestens ein Druckwerk bewegt wird, wobei der Bedruckstoff (10; 19) zum Drucken der Funktionalität elektrische Leitfähigkeit und/oder der Funktionalität elektrische Halbleitfähigkeit durch mindestens eine, mit dem oder jedem Druckwerk (13, 14, 15, 16; 24, 25, 26, 27) inline geschaltete Druckeinrichtung (12; 21, 22, 23) bewegt wird, wobei in dem oder jedem Druckwerk (13, 14, 15, 16; 24, 25, 26, 27) zum Drucken der Funktionalität Farbe jeweils eine Druckfarbe auf den Bedruckstoff (11; 19) gedruckt wird, wobei der Bedruckstoff (10) zuerst durch die oder jede Druckeinrichtung (12) für die Funktionalität elektrische Leitfähigkeit und anschließend durch das oder jedes inline geschaltete Druckwerk (13, 14, 15, 16) für die Funktionalität Farbe bewegt wird und wobei in der oder jeder Druckeinrichtung (12) zum Drucken der Funktionalität elektrische Leitfähigkeit elektrische Leiterbahnen auf den Bedruckstoff (19) gedruckt werden, **dadurch gekennzeichnet, dass** im Anschluss an das Drucken der Funktionalität elektrische Leitfähigkeit und einer hierdurch ausgebildeten Antenne ein Chip, insbesondere ein passiver oder semipassiver oder ein aktiver RFID-Tag, auf den Bedruckstoff (10) elektrisch kontaktierend mit der Antenne aufgebracht, insbesondere aufgeklebt, wird und dass der Chip im Anschluss an das Drucken der Funktionalität Farbe aufgebracht, insbesondere aufgeklebt, wird.

2. Verfahren nach Anspruch 1, **dadurch gekennzeichnet, dass** in Druckeinrichtungen (21, 22, 23) zum Drucken der Funktionalität elektrische Halbleitfähigkeit halbleitfähige Materialen, isolierende Materialen und leitfähige Materialen auf den Bedruckstoff (19) gedruckt werden.

3. Verfahren nach Anspruch 2, **dadurch gekennzeichnet, dass** die halbleitfähigen Materialen, die isolierenden Materialen und die leitfähigen Materialen derart auf den Bedruckstoff (19) gedruckt werden, dass Transistoren und aus Transistoren zusammengefügte Halbleiterchips bereitgestellt werden.

4. Verfahren nach Anspruch 2 oder 3, **dadurch gekennzeichnet, dass** der Bedruckstoff (19) vorzugsweise zuerst durch die oder jede Druckeinrichtung (21, 22, 23) für die Funktionalität elektrische Halbleitfähigkeit und vorzugsweise anschließend durch das oder jedes inline geschaltete Druckwerk (24, 25, 26, 27) für die Funktionalität Farbe bewegt wird.

5. Verfahren nach einem oder mehreren der obigen Ansprüche, **dadurch gekennzeichnet, dass** inline eine Schutzschicht auf die gedruckten elektrischen Leiterbahnen oder die gedruckten halbleitfähigen Strukturen aufgebracht wird.

## Claims

1. A method for printing a substrate, wherein the substrate is moved through at least one printing couple for printing the functionality colour, wherein the substrate (10; 19) for printing the functionality electric conductivity and/or the functionality electric semi-conductivity is moved through at least one printing device (12; 21, 22, 23) connected in line with the or each printing couple (13, 14, 15, 16; 24, 25, 26, 27),
wherein in the or each printing couple (13, 14, 15, 16; 24, 25, 26, 27) a print colour each is printed onto the substrate (11; 19) for printing the functionality colour,
wherein the substrate (10) is first moved through the or each printing device (12) for the functionality electric conductivity and following this through the or each printing couple (13, 14, 15, 16) for the functionality colour which is connected in line and wherein in the or each printing device (12) for printing the functionality electric conductivity electric conductor paths are printed onto the substrate (19),
**characterized in that** following the printing of the functionality electric conductivity and an aerial formed thereby a chip, in particular a passive or semi-passive or active RFID tag is applied, in particular glued onto the substrate (10) being electrically in contact with the aerial and **in that** the chip following the printing of the functionality colour is applied, in particular glued on.

2. The method according to Claim 1, **characterized in that** in printing devices (21, 22, 23) for printing the functionality electric semi-conductivity, semi-conductive materials, insulating materials and conductive materials are printed onto the substrate (19).

3. The method according to Claim 2, **characterized in that** the semi-conductive materials, the insulating materials and the conductive materials are printed onto the substrate (19) in such a manner that transistors and semi-conductor chips assembled from transistors are provided.

4. The method according to Claim 2 or 3, **characterized in that** the substrate (19) is preferentially first moved through the or each printing device (21, 22, 23) for the functionality electric semi-conductivity and preferentially following this through the or each printing couple (24, 25, 26, 27) connected in line for the functionality colour.

5. A method according to any one or multiple of the above claims, **characterized in that** a protective layer is applied onto the printed electric conductor paths or the printed semi-conductive structures in line.

## Revendications

1. Procédé d'impression d'un support d'impression, dans lequel le support d'impression est déplacé pour imprimer la fonctionnalité couleur dans au moins un groupe d'impression, le support d'impression (10 ; 19) étant déplacé pour imprimer la fonctionnalité conductivité électrique et/ou la fonctionnalité semi-conductivité électrique dans au moins un dispositif d'impression (12 ; 21, 22, 23) branché en ligne avec le ou chaque groupe d'impression (13, 14, 15, 16 ; 24, 25, 26, 27),
dans lequel, dans le ou chaque groupe d'impression (13, 14, 15, 16 ; 24, 25, 26, 27), pour imprimer la fonctionnalité couleur, respectivement une encre d'impression est imprimée sur le support d'impression (11 ; 19),
dans lequel le support d'impression (10) est d'abord déplacé dans le ou chaque dispositif d'impression (12) pour la fonctionnalité conductivité électrique puis dans le ou chaque groupe d'impression (13, 14, 15, 16) branché en ligne pour la fonctionnalité couleur et dans lequel, dans le ou chaque dispositif d'impression (12), pour l'impression de la fonctionnalité conductivité électrique, des circuits imprimés électriques sont imprimés sur le support d'impression (19),
**caractérisé en ce que**, à la suite de l'impression de la fonctionnalité conductivité électrique et d'une antenne ainsi constituée une puce, en particulier une balise RFID passive ou semi-passive ou active, est appliquée, en particulier collée, sur le support d'impression (10) en contact électrique avec l'antenne, et que la puce est appliquée, en particulier collée, à la suite de l'impression de la fonctionnalité couleur.

2. Procédé selon la revendication 1, **caractérisé en ce que** des matériaux semi-conducteurs, isolants et des matériaux conducteurs sont imprimés dans des dispositifs d'impression (21, 22, 23) sur le support d'impression (19) pour imprimer la fonctionnalité semi-conductivité électrique.

3. Procédé selon la revendication 2, **caractérisé en ce que** les matériaux semi-conducteurs, les matériaux isolants et les matériaux conducteurs sont imprimés sur le support d'impression (19) de manière à créer des transistors et des puces semi-conductrices constituées de transistors.

4. Procédé selon la revendication 2 ou 3, **caractérisé en ce que** le support d'impression (19) est déplacé d'abord dans le ou chaque dispositif d'impression (21, 22, 23) pour la fonctionnalité semi-conductivité électrique et de préférence ensuite dans le ou chaque groupe d'impression branché en ligne (24, 25, 26, 27) pour la fonctionnalité couleur.

5. Procédé selon une ou plusieurs des revendications précédentes, **caractérisé en ce qu'**une couche protectrice est appliquée en ligne sur les circuits imprimés électrique ou les structures semi-conductrices imprimées.
